# EUROPEAN PATENT APPLICATION

(11) **EP 1 229 590 A1**
(43) Date of publication of application: **07.08.2002**
(21) Application number: 01300880.0
(22) Date of filing: 31.01.2001
(51) Int. Cl.: H01L 29/76

(54) **Correlated charge transfer device and a method of fabricating a correlated charge transfer device**

(71) Applicant: Japan Science and Technology Corporation, Kawaguchi-shi, Saitama 332-0012 (JP); HITACHI EUROPE LIMITED, Maidenhead, Berkshire, SL6 8YA (GB); CAMBRIDGE UNIVERSITY TECHNICAL SERVICES LIMITED, Cambridge CB2 1TS (GB)
(72) Inventor: Kamiya, Toshio, Cambridge CB4 3EU (GB); Durrani, Zahid Ali Khan, Cambridge CB3 0DE (GB); Tan, Young Tong, Cambridge CB5 8DR (GB); Ahmed, Haroon, Master's Lodge, Cambridge CB2 1RH (GB); Mizuta, Hiroshi, Cambridge CB4 6DS (GB); Furuta, Yoshikazu, Cambridge CB3 2DW (GB)
(74) Representative: Read, Matthew Charles

(57) **Abstract**

A single-electron transistor (1) has a point-contact channel (2) and side gates (5) formed in a granular layer (6). The granular layer is fabricated by depositing a nanocrystalline silicon layer (6') using plasma-enhanced chemical vapour deposition (PECVD), carrying out oxidation in dry oxygen at 750 °C and performing an anneal in argon at 1000 °C. The granular layer comprises crystalline conductive regions (9) and amorphous insulating regions (10), wherein the amorphous region forms a tunnel barrier with a height greater than 100 meV. The single-electron transistor exhibits Coulomb blockade at room temperature.

## Description

The present invention relates to a correlated charge transfer device and a method of fabricating a correlated charge transfer device, particularly, although not exclusively, to a single-electron transistor and a method of fabricating a single-electron transistor.

A metal-oxide-semiconductor field effect transistor (MOSFET) is one of the most important types of electronic device used in integrated circuits (ICs). Over the past few decades, the size of the MOSFET has been steadily reduced in order to achieve greater packing densities and faster performance. The number of charge carriers used to operate the device has also been reduced, resulting in lower power consumption. However, scope for further size reductions is restricted since device parameters such as gate oxide thickness and channel length are reaching fundamental limits.

New types of device which operate using different principles are being considered to replace or augment existing devices such as the MOSFET. A single-electron transistor (SET) is one such device in which Coulomb blockade is employed to control charge carrier transfer through the device.

In its simplest form, a device which operates using Coulomb blockade comprises a single conductive island which is isolated from a source and a drain by a pair of tunnel barriers. The island is electrically isolated and so only an integer number of free charge carriers can occupy it. Work must be done to charge the island. If an extra charge carrier is added to the island then the potential energy of the island is raised by a charging energy E_{C} ≈ e²/C, where C is the capacitance of the island and e is the value of electronic charge. For current to flow, the extra charge carrier tunnels from the source onto the island and off again to the drain. A bias voltage V is applied between the source and drain to drive this process. However, if the bias is insufficient to overcome the charging energy, then the extra charge carrier cannot tunnel onto the island. Consequently, current flow is suppressed. This is Coulomb blockade. Only when a sufficiently large bias is applied so as to overcome the charging energy can the extra charge carrier tunnel onto the island and thus allow current to flow. Furthermore, while the extra charge carrier occupies the island, further charge carriers are prevented from tunnelling onto the island since this will raise the potential energy of the island by an additional quanta of the charging energy. Therefore, charge carrier transfer on and off the island occurs in strict sequence, i.e. charge transfer is correlated. A gate electrode may be added to raise and lower the potential energy of the island and so switch the device between blockade and non-blockade regimes.

Coulomb blockade begins to have an appreciable effect at sub-micrometre dimensions. Only then do the biases at which the device switches become large enough to be useable in logic and memory circuits. Furthermore, a large charging energy is also necessary to operate the device above liquid helium temperature, i.e. 4.2 K, since Coulomb blockade will not occur if the thermal energy k_{B}T is greater than the charging energy. Thus, for room temperature operation the capacitance of the islands should be less than about 1aF and so the size of the islands should be less than about 10nm.

Such small dimensions, coupled with the necessity for precise alignment, make large-area circuit fabrication of SETs using conventional fabrication techniques difficult. In light of this, attention is being directed to material systems in which isolated conductive islands occur naturally. For instance, granular films are deposited by evaporating a thin layer of metal under vacuum conditions. In another example, self-organised islands form when metals or semiconductors are grown on specific substrates.

Unfortunately, these specialised techniques are usually incompatible with existing integrated circuit fabrication processes. However, SETs have been fabricated using thin, polycrystalline silicon films using a side-gated ultra-thin wire, or "nanowire" and an example is described in "Single-electron effects in heavily doped polycrystalline silicon nanowires" by Andrew C. Irvine, Zahid A. K. Durrani, Haroon Ahmed and Serge Biesemans, Applied Physics Letters, Volume 73, pp. 1113-1115 (1998). In this example, a heavily doped silicon nanowire is thinned and passivated by forming a silicon oxide layer on its surface using a high-temperature oxidation process. Grains of polycrystalline silicon form conductive islands and tunnel barriers form at grain boundaries. In another example, conductive islands are created in a silicon-rich silicon oxide layer and an example is described in "Memory effects in MOS capacitors with silicon rich oxide insulators " by S. Lombardo *et al.,* page A 29.1.1 of "Amorphous and Heterogeneous Silicon Thin Films 2000", Materials Research Society Proceedings Volume 609 (2000).

However, both these types of SET operate below 77 K and so need to be cooled using costly liquid helium. Nevertheless, an SET has been fabricated as part of a memory device using an ultra thin polycrystalline silicon film and operates at room temperature. The device is described in "Single-Electron Memory for Giga-to-Tera Bit Storage" by K. Yano *et al*., Proceedings of the IEEE, volume 87, pp. 633-651 (1999). However, this type of SET uses a discontinuous film and has a high device resistance, with low current densities, which result in the memory device having a large value of RC and slow read/write times.

The present invention seeks to provide an improved single-electron device and an improved method of fabricating a single-electron device.

According to a first aspect of the present invention there is provided a correlated charge transfer device which includes a conductive channel comprising a crystalline conductive region and an amorphous insulating region, wherein the insulating region is configured to form a potential barrier relative to the conductive region with a height of at least 100 meV so as to allow the device to exhibit Coulomb blockade at room temperature. By room temperature, we mean about 300 K.

The amorphous insulating region may be configured so that the conductive region has a capacitance of about 1 aF or less

The amorphous insulating region may have a thickness of 10 nm or less. The amorphous insulating region may have a thickness of 2 nm or less.

The crystalline conductive region may comprise a crystalline grain, having a diameter of 30 nm or less, 20 nm or less or 10 nm or less, for instance between 4 to 8 nm. The crystalline grain may be columnar or spherical.

The crystalline conductive region may comprise a further crystalline grain.

The crystalline conductive region may comprise semiconductor material, such as silicon and may be doped with an impurity, such as an electron donor for example phosphorous or arsenic, to a concentration above 1×10¹⁹cm⁻³. The impurity may be doped to a concentration above 1×10²⁰cm⁻³.

The amorphous insulating region may comprise a material comprising silicon atoms and may further include oxygen atoms, which comprise at least 25%, but no more than 67%, of the material. The material may further include nitrogen atoms, which comprise at least 50% of the material. The material may further include carbon atoms, which comprise at least 50% of the material. The material may further include hydrogen atoms, which comprise at least 2% of the material.

The channel may be arranged as a layer and may have a thickness of 30 nm. The layer may be continuous. The channel may be less than 50 nm long and 50 nm wide, for instance less than 30 nm wide. The channel may include a further crystalline conductive region, wherein the amorphous insulating region is disposed between the crystalline conductive regions. The amorphous insulating region may form a matrix.

The device may further comprise a source and a drain disposed at either end of the channel. The device may further comprise a gate electrode, which may be configured as a side gate.

According to a second aspect of the present invention there is also provided a memory device comprising the correlated charge transfer device. The memory device may further comprise a metal-oxide-semiconductor field effect transistor (MOSFET).

According to a third aspect of the present invention there is also provided a logic device comprising the correlated charge transfer device.

According to a fourth aspect of the present invention there is also provided a method of fabricating a correlated charge transfer device which includes a conductive channel comprising a crystalline conductive region and an amorphous insulating region configured to form a potential barrier relative to the conductive region whereby to allow the device to exhibit Coulomb blockade, the method comprising treating the amorphous insulating region so that it exhibits a tunnel barrier height of at least 100 meV.

The treatment may comprise preferentially introducing a reagent into the amorphous insulating region over the crystalline conductive region. The preferential introduction of the reagent into the amorphous insulating region over the crystalline conductive region may comprise preferentially oxidizing the amorphous insulating region over the crystalline conductive region. The treatment may further comprise annealing the amorphous insulating region.

The treatment may comprises preferentially oxidizing the amorphous insulating region over the crystalline conductive region and annealing the amorphous insulating region. The preferential oxidization may be performed at a relatively low temperature and the annealing may be carried out at a relatively high temperature. The oxidization may be performed between 500 and 800 °C, for example at about 750 °C. The annealing may be carried out at between 900 and 1100 °C, for example at about 1000 °C.

The treatment may include using O₂, H₂O or H₂O₂. The treatment may also include using N₂, NH₃, N₂O, NO, NO₂, HCN, C, CO or CO₂.

The method may further comprise providing a substrate and depositing a film over the substrate comprising the conductive crystalline and amorphous insulating regions. The deposition may comprises mixing halogenated silane, silane and hydrogen feed gases. The mixing of the feed gases may comprise using a ratio of halogenated silane to hydrogen equal or less than 1. The deposition may comprise heating the substrate to at least 300 °C.

The method may further comprise patterning the film to define the conductive channel.

According to a fifth aspect of the present invention there is provided apparatus for performing the method.

Embodiments of the present invention will now be described, by way of example, with reference to the accompanying drawings in which:-
Figure 1 is a plan view of a correlated charge transfer device according to the present invention;
Figure 2 is a cross section of the device taken along a line A-A' in Figure 1;
Figure 3 is an enlarged view of part of the device shown in Figure 1;
Figure 4 is plot of current against voltage between the source and the drain of the device shown in Figure 1 at different temperatures;
Figure 5 is a plot of source-drain current against gate voltage for the device shown in Figure 1 at different temperatures;
Figure 6 is plot of current against voltage between the source and the drain of the device shown in Figure 1 at different gate voltages;
Figure 7 is a plot of source-drain current against gate voltage for the device shown in Figure 1 at different source-drain voltages;
Figures 8a to 8d show a fabrication sequence of the device shown in Figure 1;
Figure 9 is transmission electron micrograph of a nanocrystalline film;
Figures 10a and 10b are scanning electron micrographs of the device shown in Figure 1 before and after an oxidation step;
Figure 11 is a plan view of another device according to the present invention;
Figure 12 is a cross section of the device shown in Figure 11;
Figure 13 is an enlarged view of the cross section shown in Figure 12;
Figures 14a to 14d show a fabrication sequence of the device shown in Figure 11;
Figure 15 is a schematic diagram of a memory circuit including a correlated charge transfer device according to the present invention;
Figure 16 is a schematic diagram of a logic circuit including a correlated charge transfer device according to the present invention;
Figure 17 is a schematic diagram of apparatus for depositing nanocrystalline silicon;
Figure 18a is a schematic diagram of a first example of apparatus for treating an amorphous region according to the present invention and
Figure 18b is a schematic diagram of a second example of apparatus for treating an amorphous region according to the present invention.

### First embodiment

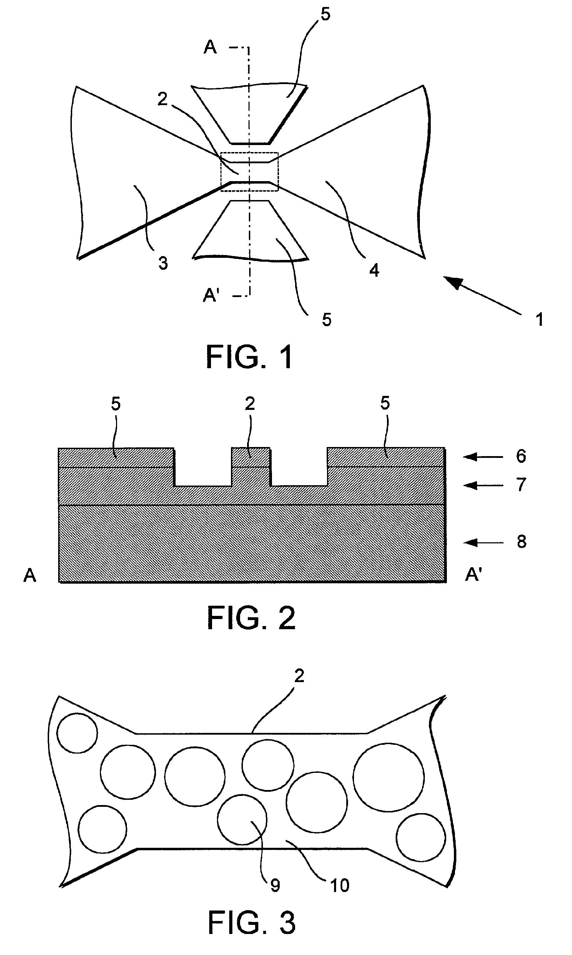

Referring to Figure 1, a first embodiment of a correlated charge transfer device according to the present invention comprises a single electron transistor (SET) 1 having a point-contact channel 2 disposed between source 3 and drain regions 4 and provided with a side gate 5 either side of the channel 2. The channel 2 is 20 nm long between the source 2 and drain 3 regions and 20 nm wide, although a narrower or shorter channel 2 may be used. The gate 5 is separated from the channel 2 by 100 nm.

Referring to Figures 1, 2 and 3, the channel 2, source 3, drain 4 and gates 5 are formed in a granular conductive layer 6 which overlies an insulating layer 7 disposed on top of a substrate 8. The substrate 8 is made of n-type single crystal silicon and the insulating layer 7 comprises silicon dioxide having a thickness of 150 nm. The granular conductive layer 6 forms a substantially continuous film having a thickness of 30nm and comprises conductive grains 9 and insulating material 10. The thickness of the granular conductive layer 6 may be less than 50 nm or greater than 10 nm. In this example, the conductive grains 9 are arranged substantially as a single row along the length of the channel 2.

The conductive grains 9 comprise crystalline silicon, doped with phosphorous with a doping density, n ≈ 1×10²⁰cm⁻³, and have diameters between 4 and 8 nm. However, the grains 9 may have diameters less than 30 nm. The grains 9 may have diameters less than 20 nm. The grains 9 may have diameters less than 10 nm. The conductive grains may be substantially spherical. The conductive grains may be columnar, upstanding from the insulating layer 7.

The insulating material 10 is amorphous material comprising silicon oxide (SiOₓ). The silicon oxide may have a ratio of silicon to oxygen atoms less than 1:2 (i.e. SiOₓ, where x<2). The silicon oxide may have a ratio of silicon to oxygen atoms between 1:0.33 and 1:2 (i.e. SiOₓ, where 0.33< x<2). The insulating material 10 is arranged between the grains 9 as a matrix. However, the insulating material 10 may be arranged substantially at boundaries between the grains 9. Adjacent grains 9 within the granular conductive layer 6 are separated from one another by less than 10 nm. However, adjacent grain separation may be less than 2 nm.

The insulating material 10 forms tunnel barriers between the conductive grains 9. The tunnel barriers have a potential energy barrier height (ϕ) of about 100 meV or greater. It is preferred that the tunnel barriers have a potential energy barrier height greater than 500 meV or even 1 eV.

The SET 1 is isolated from other devices by means of mesa (not shown) and aluminium metal pads (not shown) are used to contact the source 3, drain 4 and gate 5.

The SET 1 is arranged so as to exhibit correlated charge transfer effects. At least one grain 9 within the channel 2 behaves as an isolated conductive island and so charge flow between the source 3 and drain 4 through the SET 1 is subject to Coulomb blockade. However, a chain of many grains 9 may form a multiple tunnel junction (MTJ) array.

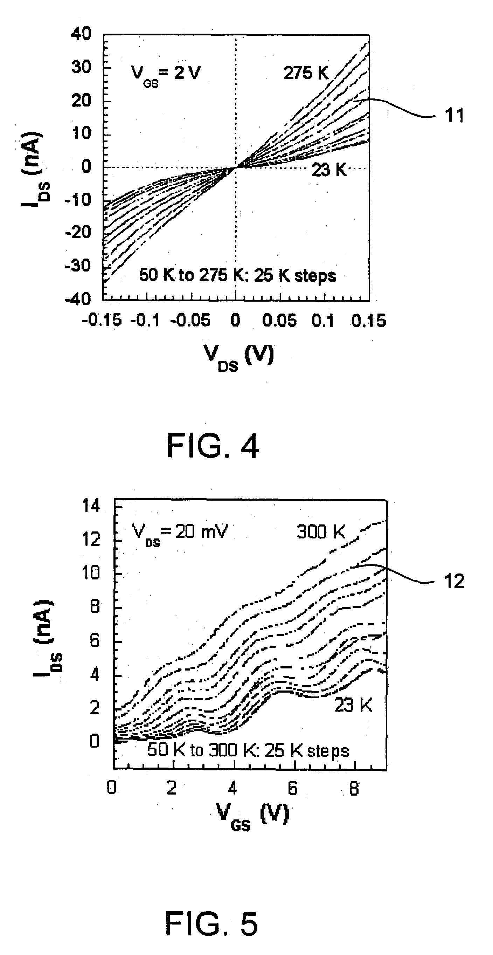

Referring to Figures 4 to 8, the electrical characteristics of the SET 1 will now be described.

In Figure 4, a set of current-voltage characteristics (I_{DS}-V_{DS}) 11 between the source 3 and the drain 4 are shown. The characteristics 11 are measured with the side gate 5 held at 2 volts relative to the source 3, i.e. V_{GS}=2V, and at temperatures ranging from 23 K (curve closest to voltage axis) and 275 K (curve furthest from the voltage axis) in 25 K steps.

In Figure 5, a set of channel current against gate voltage characteristics (I_{DS}-V_{GS}) 12 are shown. The characteristics 12 are measured with the source-drain voltage held at 20 millivolts, i.e. V_{DS} =20mV, and at temperatures ranging from 23 K (bottom curve) and 300 K (top curve) in 25 K steps.

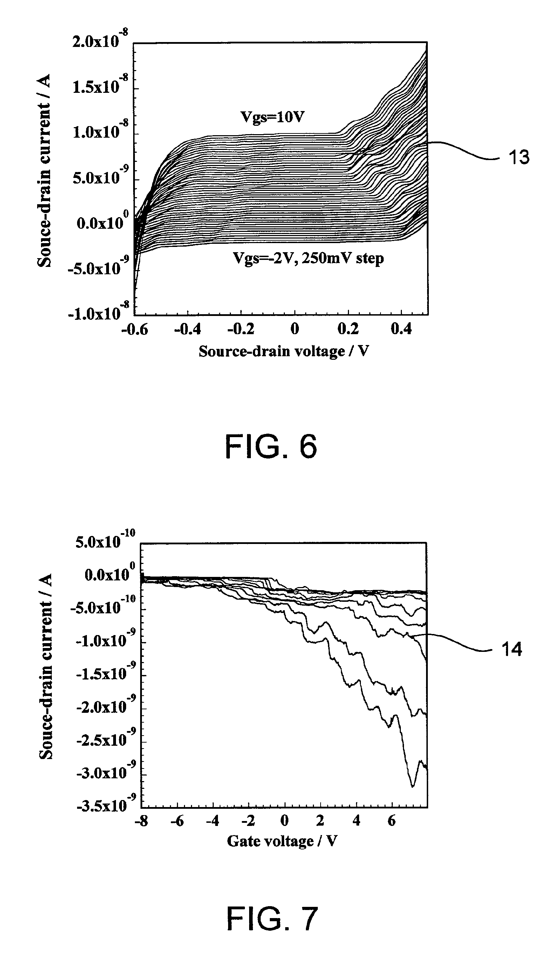

In Figure 6, a further set of current-voltage characteristics (I_{DS}-V_{DS}) 13 between the source 3 and the drain 4 are shown. The characteristics 13 are measured with the SET 1 cooled to 10 K with biases applied to the side gate 5 ranging between -2V (bottom curve) to 10V (top curve) in 0.25 V steps, i.e. -2V≤V_{GS}≤10V.

In Figure 7, a further set of channel current against gate voltage characteristics (I_{DS}-V_{GS}) 14 are shown. The characteristics 14 are measured with the SET 1 cooled to 10 K with source-drain biases ranging between -500 mV (bottom curve) to -375 mV (top curve) in 25 mV steps, i.e. -500mV≤V_{DS}≤-375V.

The SET 1 exhibits superior electrical characteristics with respect to the known polycrystalline devices. In particular, Coulomb blockade effects persists up to room temperature, i.e. about 300 K. Furthermore, the SET 1 shows strong transconductance (g). The average current density is of the order of 1000 Acm⁻² for V_{DS}=20mV. This compares to an average current density of the order of 10 Acm⁻² for V_{DS}=50mV for the device disclosed in Proceedings of the IEEE *supra.*

The operating temperature of the SET 1 is dependent not only on the charging energy of the conductive islands, i.e. the silicon crystalline grains 9, but also upon the properties of the tunnel barriers. The tunnel junctions should have a sufficiently high resistance that charge carriers are localised to the conductive islands. This condition is satisfied if the tunnel barrier resistance is greater than the quantum resistance, R_{K}≈ 25 kΩ. The tunnel barrier resistance is dependent upon the thickness of the tunnel barrier and height of the potential energy barrier. The known polycrystalline silicon SETs suffer from having poor quality tunnel barriers of low resistance. In the SET 1, the tunnel barrier height is at least 100 meV which is several times greater than thermal energy at room temperature k_{B}T ≈ 25 meV. Thus, charge carriers are localised to the conductive islands, i.e. crystalline silicon grains 9, even at room temperature. The conductive islands are also sufficiently small and have a low enough capacitance that their charging energy is suitably large compared with thermal energy at room temperature. This allows the SET 1 to operate at higher temperatures compared with prior art polycrystalline devices.

Values of gate capacitance of the order of 10⁻²⁰ F and capacitance of tunnel barriers of the order of 10⁻¹⁹ F can be determined from the electrical characteristics 12, 13, 14, 15 of the SET 1. Thus, the capacitance of at least one of the conductive grains 9 is less than 1aF. Estimates of capacitance may also be made from a calculation of self capacitance of a grain 9 and from the temperature at which charging effects begin to "wash-out".

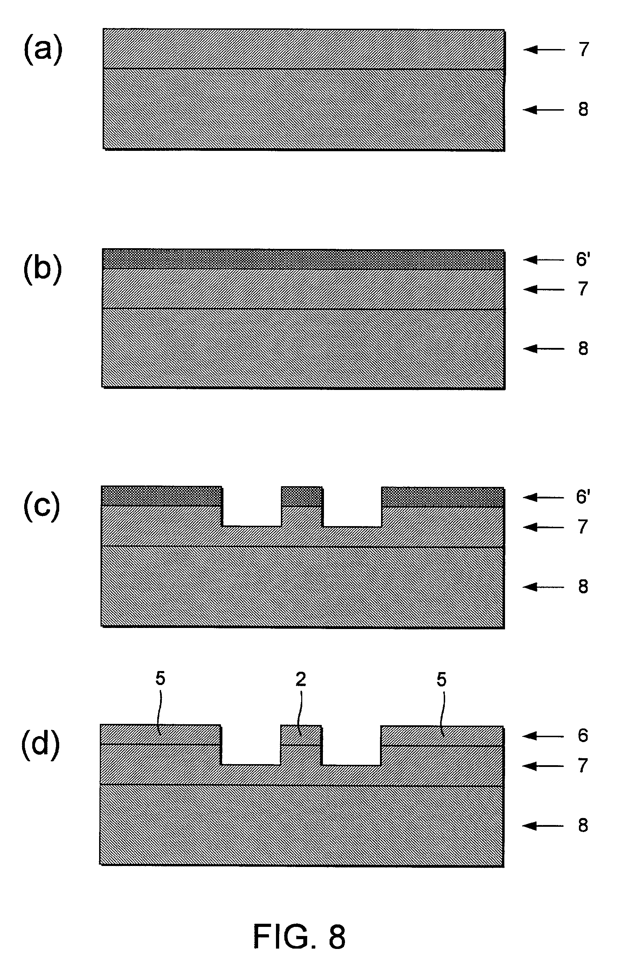

Referring to Figures 8a to 8d, a method of fabricating the SET 1 will now be described.

The silicon dioxide insulating layer 7 is grown on top of the n-type silicon substrate 8 by oxidation at 1000 °C and has a thickness of 150 nm. The corresponding layer structure is shown in Figure 8a.

It will be appreciated that the insulating layer 7 may be made thinner or thicker than 150 nm and may be deposited, for example, by chemical vapour deposition (CVD) using silane and oxygen. Other insulating layers 7 may also be used, including for instance silicon nitride and non-conductive plastic. Likewise, other substrates 8 may be used, which need not be made of silicon, nor doped. The substrate 8 and the insulating layer 7 may be combined into a single insulating substrate layer made of, for example, silicon dioxide.

A nanocrystalline silicon film 6' is deposited on top of the insulating layer 7 by plasma-enhanced chemical vapour deposition (PECVD) at 300 °C using halogenated silane (SiXₐ, SiX_{b}H_{c}; X=F, Cl), hydrogen (H₂) and silane (SiH₄) as feed gases and doped *in-situ* using phosphine (PH₃). The film 6' has a thickness of 30 nm. In this example, silicon tetrafluouride (SiF₄) is used as the halogenated silane and gas flow rates are 30 sccm for SiF₄, 40 sccm for H₂ and 0.25 sccm for SiH₄. A ratio of 2% phosphine to silane is used. The corresponding layer structure is shown in Figure 8b.

About 70% of the film 6' comprises crystalline silicon grains with the remainder being amorphous silicon disposed between the crystalline silicon material. The crystalline silicon material has a grain size between about 4 and 8 nm. The film 6' has a Hall mobility of the order of 1 cm²V⁻¹s⁻¹. The structure of the nanocrystalline silicon film 6' is discussed in more detail hereinafter.

The surface of the nanocrystalline layer 6' is patterned using conventional optical lithographic techniques and a CF₄ reactive ion etch (RIE) is used to remove portions of the nanocrystalline layer 6' and part of the insulating layer 7 so as to define a mesa (not shown) which isolates the SET 1 from other devices.

Then, the surface of the nanocrystalline layer 6' is patterned using conventional electron beam lithographic techniques a CF₄ reactive ion etch (RIE) is used to remove portions of the nanocrystalline layer 6' and part of the insulating layer 7 so as to define the channel 2, source 3, drain 4 and gate 5. The corresponding structure is shown in Figure 8c.

A further step of electron beam lithography is included to define large-area portions (not shown) of the source 3, drain 4 and gate 5.

A native oxide on the remaining surfaces of the nanocrystalline layer 6' is removed, for example using a Laporte SILOX dip.

The nanocrystalline layer 6' is selectively oxidized in dry oxygen at about 750 °C, for one hour and then annealed in argon about 1000 °C, for 15 minutes. Oxidation may be carried out between 500 and 850 °C, preferably at atmospheric pressure. Annealing may be carried out between 900 to 1100 °C, preferably at atmospheric pressure. The corresponding structure is shown in Figure 8d.

The effect of the oxidation and annealing steps is to convert the nanocrystalline layer 6' into the granular layer 6 shown in Figure 1 and will be discussed in more detail hereinafter.

Finally, the surface is patterned using conventional optical lithographic techniques to define aluminium bond pads (not shown) on the large-area portions (not shown) of the source 3, drain 4 and gate 5.

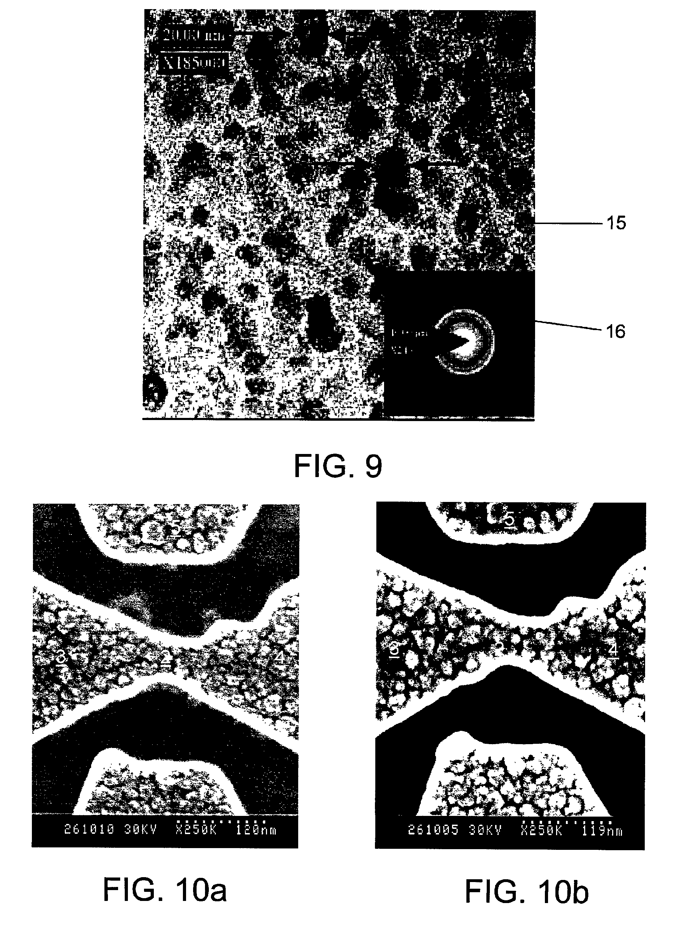

Referring to Figure 9, a transmission electron micrograph 15 of the nanocrystalline silicon film 6', including diffraction rings 16 which indicate the presence of crystalline material, is shown. The film 6' comprises crystalline grains and amorphous regions. The size and volume fraction of the crystalline regions may be controlled according to substrate temperature, the ratio of halogenated silane to hydrogen feed gasses, doping concentration and the thickness of the film.

Referring to Figures 10a and 10b, the effect of the oxidation and annealing steps on the nanocrystalline silicon layer 6' will now be described.

The structure as shown in Figure 8b and 10a with the nanocrystalline silicon film 6' exhibits Coulomb blockade which persists up to 60 K. Higher temperature operation is prevented because the tunnel barrier provided by the amorphous silicon regions between the nanocrystalline silicon grains do not have a sufficiently large barrier height to support Coulomb blockade. In the nanocrystalline silicon film 6', the barrier height between the grains is about 30 meV. The oxidation and annealing steps result in a raising of the tunnel barrier height to allow room temperature operation. The oxidation step causes oxygen to diffuse into specific regions of the film 6', such as the amorphous silicon region, where Si-O chemical bonds are formed. The oxidized nanocrystalline film 6' is shown in Figure 10b. The effect of the annealing step is to improve the oxide quality. The effective channel width is also reduced due to surface and side oxidation. The result is granular layer in which the barrier height is increased to about 100 meV or greater.

It will be appreciated that values of oxidation temperature and time and annealing temperature and time are dependent upon properties of the nanocrystalline film 6', such as grain size and the amount of amorphous material between grains.

The multiple step oxidation and annealing process has advantages over a single step oxidation process. If oxidation is carried out at a high temperature, for example 1000 °C, the rate of oxidation is too high for the thickness of the silicon oxide layer to be controlled precisely. Furthermore, a high temperature process may cause the grains to grow, thus increasing their capacitance and lowering the SET 1 operating temperature. The low temperature oxidation step does not cause substantial grain growth. If oxidation is carried out at a lower temperature, without an annealing step, the quality of the oxide is poorer.

### Second embodiment

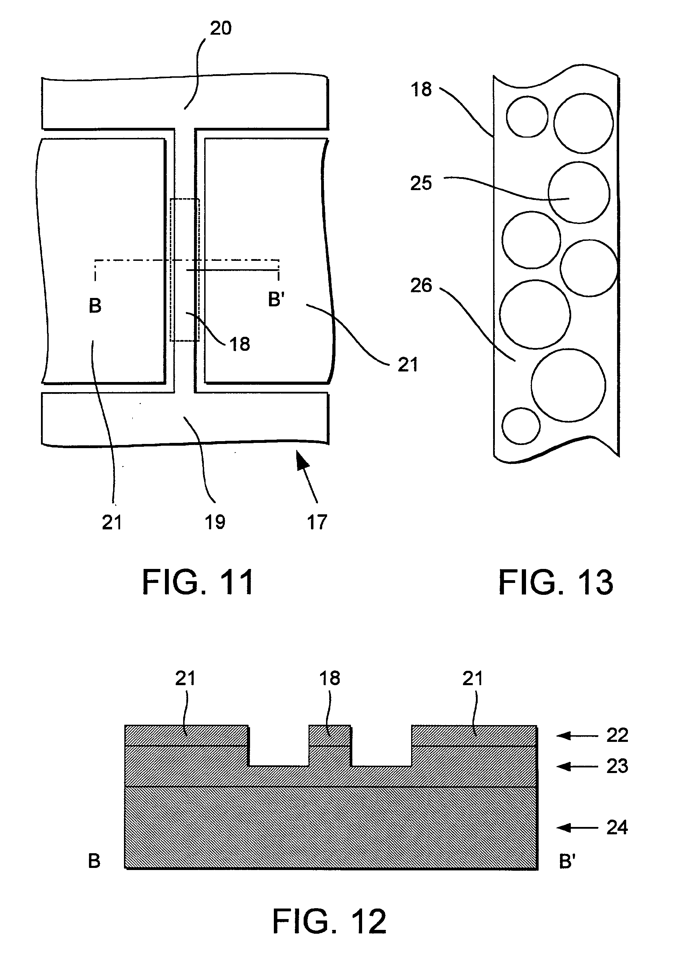

Referring to Figure 11, a second embodiment of a correlated charge transfer device according to the present invention comprises a single electron transistor (SET) 17 having a nanowire channel 18 disposed between source 19 and drain regions 20 and provided with a side gate 21 either side of the channel 18. The channel 18 is 1µm long between the source 19 and drain 20 regions and 40 nm wide. The side gate 21 and the channel 18 are separated by 120 nm.

Referring to Figures 11, 12 and 13, the channel 18, source 19, drain 20 and gates 21 are formed in a granular conductive layer 22 which overlies an insulating layer 23 disposed on top of a substrate 24. The substrate 24 is made of p-type single crystal silicon and the insulating layer 23 comprises silicon dioxide having a thickness of 40 nm. The granular conductive layer 22 forms a substantially continuous film, 30 nm thick and comprises conductive grains 25 and insulating material 26.

The conductive grains 25 comprise crystalline silicon, doped with phosphorous with a doping density, n ≈ 5×10¹⁹cm⁻³, having a diameter of about 10 nm. The grains 25 may have a diameter less than 10 nm. The conductive grains 25 may be columnar, upstanding from the insulating layer 23, having diameters less than 20 nm.

The insulating material 26 is amorphous material and comprises silicon oxide (SiOₓ). The silicon oxide may have a ratio of silicon to oxygen atoms less than 1:2 (i.e. SiOₓ, where x<2). The ratio may be between 1:0.33 and 1:2 (i.e. SiOₓ, where 0.33< x<2). The insulating material 26 is arranged between the grains 25 as a matrix. However, the insulating material 26 may be arranged substantially at boundaries between the grains 25. Adjacent grains 15 within the granular conductive layer 22 are separated from one another by less than 10 nm. However, adjacent grain separation may be less than 2 nm.

The SET 17 is isolated from other devices by means of mesa (not shown) and aluminium metal pads (not shown) are used to contact the source 19, drain 20 and gate 21.

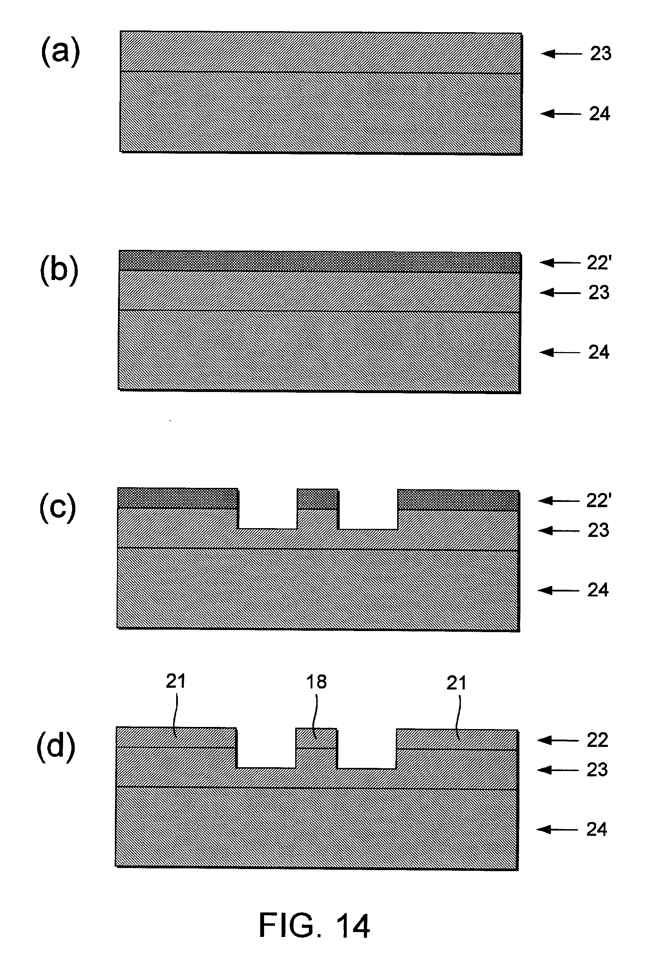

Referring to Figures 14a to 14d, a method of fabricating the SET 17 will now be described.

The silicon dioxide insulating layer 23 is grown on top of the p-type silicon substrate 24 by oxidation at 1000 °C and has a thickness of 40 nm. The corresponding layer structure is shown in Figure 14a.

It will be appreciated that the insulating layer 23 may be made thinner or thicker and may be deposited, for example, by chemical vapour deposition (CVD) using silane and oxygen. Other insulating layers 23 may also be used, including for instance silicon nitride. Likewise, other substrates 24 may be used, which need not be made of silicon, nor doped. The substrate 24 and the insulating layer 23 may be combined into a single insulating substrate layer made of, for example, silicon dioxide.

An amorphous silicon film is deposited on top of the insulating layer 23 by LPCVD using hydrogen (H₂), silane (SiH₄) as feed gases and has a thickness of 50 nm. The amorphous silicon film is doped by ion implantation of phosphorous at 20kV. The doped amorphous film is converted into a nanocrystalline silicon film 22' by solid-phase crystallisation at about 850 °C for 30 minutes. The corresponding layer structure is shown in Figure 14b.

The surface of the nanocrystalline layer 22' is patterned using conventional optical lithographic techniques and a CF₄ reactive ion etch (RIE) is used to remove portions of the nanocrystalline layer 22' and part of the insulating layer 23 so as to define a mesa (not shown) which will isolate the SET 17 from other devices.

The surface of the nanocrystalline layer 22' is patterned using conventional electron beam lithographic techniques a CF₄ reactive ion etch (RIE) is used to remove portions of the nanocrystalline layer 22' and part of the insulating layer 23 so as to define the channel 18, source 19, drain 20 and gate 21. The corresponding structure is shown in Figure 14c.

A further step of electron beam lithography is included to define large-area portions (not shown) of the source 19, drain 20 and gate 21.

A native oxide on the remaining surfaces of the nanocrystalline layer 6' is removed, for example using a Laporte SILOX dip.

The nanocrystalline layer 22' is selectively oxidized in dry oxygen at about 750 °C, for 1 hour and annealed in argon at about 1000 °C and for 15 minutes. Oxidation may be performed at a relatively low temperature and annealing may be performed at relatively high temperature. Oxidation may be carried out between 650 and 850 °C. Annealing may be carried out between 900 to 1100 °C. The corresponding structure is shown in Figure 8d.

The effect of the oxidation and annealing steps is to convert the nanocrystalline layer 22' into the granular layer 22 shown in Figure 11.

Finally, the surface is then patterned using conventional optical lithographic techniques to define aluminium bond pads (not shown) on the large-area portions (not shown) of the source 19, drain 20 and gate 21.

Further details of the fabrication process, in particular deposition of the amorphous silicon film and solid phase crystallisation, may be found in "Electrical and structural properties of solid phase crystallised polycrystalline silicon and their correlation to single-electron effects" by Y. T. Tan, Z . A. K. Durrani and H. Ahmed, Journal of Applied Physics, Volume 89, pp.1262-1270 (2001).

The SETs 1, 17 may be incorporated into memory or logic devices.

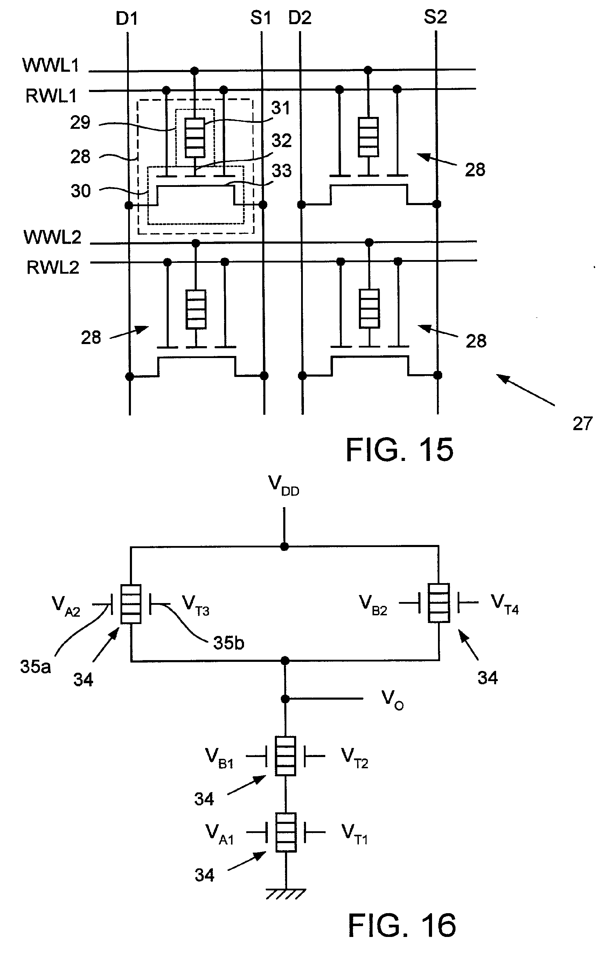

Referring to Figure 15, memory 27 may be constructed from an array of memory cells 28 each comprising an SET 29 according to the present invention, such as the SET 1, 17, and a split gate channel MOSFET 30. The cells 28 are controlled by a read word lines (RWL 1, RWL 2), write word lines (WWL 1, WWL 2) and a data input lines (D1, D2). Charge is written through the channel 31 of the SET 29 to a memory node 32 so as to control conductivity of a MOSFET channel 33.

Details of how to integrate an SET and a MOSFET into a memory cell and how to operate the memory cell may be found in "A memory cell with single-electron and metal-oxide-semiconductor transistor integration" by Zahid A. K. Durrani, Andrew C. Irvine, Haroon Ahmed and Kazuo Nakazato, Applied Physics Letters, Volume 74, pp. 1293-1295 (1999) and in "Coulomb blockade memory using integrated single-electron transistor/metal-oxide semiconductor transistor gain cells" by Zahid A. K. Durrani, Andrew C. Irvine, Haroon Ahmed, IEEE Transactions on Electron Devices, Volume 47, pp. 2334-2339 (2000).

Referring to Figure 16, a NAND circuit may be constructed from a four SETS 34. The SETs 34 are arranged between a supply rail V_{DD} and ground and are controlled by side gates 35. Each arm of each side gate 35 is operated separately. A first arm 35a is used to supply a logic input voltage (V_{A1}, V_{A2}, V_{B1}, V_{B2}), a second arm 35b is used to bias each SET 34 with a trimming voltage (V_{T1}, V_{T2}, V_{T3}, V_{T4}).

Details of how to construct such a NAND gate and to operate it may be found in "Logic circuit elements using single-electron tunnelling transistors " by N.J. Stone and H. Ahmed, Electronics Letters, Volume 35, pp. 1-2 (1999).

The SETs 1, 17 may also be incorporated into logic circuits having an architecture based upon binary decision diagram (BDD) in which an array of possible current paths are connected by two-way switching nodes that have a clear ON-OFF switching characteristic. Details of how to construct such an AND gate using BDD may be found in "Operation of logic function in a Coulomb blockade device" by K. Tsukagoshi, B. W. Alphenaar and K. Nakazato, Applied Physics Letters, Volume 73, pp. 2515-2517 (1998).

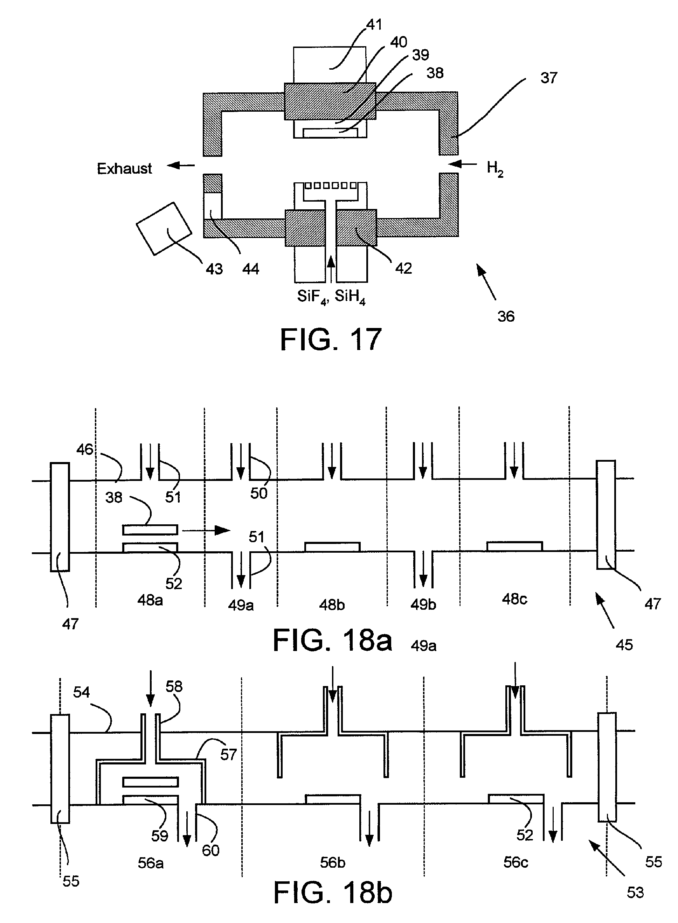

Referring to Figure 17, apparatus for depositing nanocrystlline silicon comprises an PECVD system 36, comprising a chamber 37 in which a substrate 38 is held in a holder 39 mounted on an anode 40. The anode 40 is heated by a heater 41. A plasma is generated between the anode 40 and a cathode 41 through which feed gases such as SiF₄ and SiH₄ are introduced, the flow of which is controlled using mass flow controllers. The cathode may also be heated. The cathode is connected to a matching box (not shown) fed from a VHF power supply (not shown). H₂ may be introduced separately, since this is used in pump/purging cycles. Exhaust gases are pumped out using a pump (not shown). The pressure within the chamber 37 is controlled by throttling pumping controlled by an automatic pressure controller (not shown). Deposition can be monitored using an optical emission spectroscope 43 through a window 44 in the chamber 37.

Referring to Figure 18a, apparatus for treating the amorphous silicon comprises a system 45 comprising a chamber 46 having gate valves 47 at either end. The substrate 38 having a nanocrystalline layer deposited thereon passes through a plurality of stages 48a, 48b, 48c, separated by inert gas showers 49a, 49b provided by an inert gas inlet 50 and an inert gas outlet 51. Each stage 48 has a gas inlet 52 for a process gas, for example oxygen, ammonia or argon and a heater 53, such as an infra red heater or an electric heater. Each stage may be separated by a separate gate valve. The substrate 38 passed from one stage 48 to another so as to be subjected to a reagent, such as oxygen, or annealled. It will be appreciated the system 45 may be connected directly to other processing apparatus. The system may also have a pump connected to it, which may be used for pump/purging cycles, cleaning or operating the system 45 at controlled pressure.

Referring to Figure 18b, apparatus for treating the amorphous silicon comprises a different system 53 comprising a chamber 54 having gate valves 55 at either end. The substrate 38 having a nanocrystalline layer deposited thereon passes through a plurality of stages 56a, 56b, 56c. Each stage 56 has its own moveable cup 57 including a gas inlet 58 for a process gas, for example oxygen, ammonia or argon. Each stage 56 also has a heater 59, such as an infra red heater or an electric heater, a gas outlet 60. When the substrate 38 enters a stage 56 and the cup 57 moves into a closed position so as to isolate the substrate 57 from the rest of the system 53 and process gas is introduced into the isolated space during which the heater 59 is operated. After the process has finished, the cup 57 moves into an open position and the substrate 38 is free to pass through the system 53 to the next stage 56. In this way the substrate 38 passes from one stage to another where it is subjected to a reagent, such as oxygen, or annealled. It will be appreciated the system may be connected directly to other processing apparatus. The system may also have a pump connected to it, which may be used for pump/purging cycles, cleaning or operating the system 45 at controlled pressure.

It will be appreciated that the number of stages may depend on the number of processing steps. Thus, if a single oxidation and single annealing step is performed then two stages are required.

Apparatus for carrying out the oxidation and annealing step may comprise a cluster of reaction chambers.

It will be appreciated that many modifications may be made to the embodiments herein before described. For example, the oxidation step may use H₂O or H₂O₂. The oxidation step may be replaced by or supplemented with a nitridation step using a suitable nitrating compound, for example NH₃, N₂, N₂O, NO or NO₂. Alternatively or additionally, a carbonizing step may be included using a suitable carbonizing compound, for example carbon, HCN, CO or CO₂. Thus, using a mixture of gases oxygen, nitrogen and/or carbon species may be introduced into and may react with the amorphous silicon layer.

A further oxidizing step may be included. The further oxidizing step may be carried under the same conditions as the first oxidation step. These conditions may include temperature, pressure, process time or oxygen flow rate.

A further annealing step may be included. The further annealing step may be carried under the same conditions as the first annealing step.

## Claims

1. A correlated charge transfer device (1) which includes a conductive channel (2) comprising a crystalline conductive region (9) and an amorphous insulating region (10), **characterised in that**
the insulating region is configured to form a potential barrier relative to the conductive region with a height of at least 100 meV so as to allow the device to exhibit Coulomb blockade at room temperature.

2. A device according to claim 1, wherein the amorphous insulating region (10) is configured so that the conductive region (9) has a capacitance of about 1 aF or less

3. A device according to claim 1 or 2, wherein the amorphous insulating region (10) has a thickness of 10 nm or less.

4. A device according to any preceding claim, wherein the amorphous insulating region (10) has a thickness of 2 nm or less.

5. A device according to any preceding claim, wherein the crystalline conductive region (9) comprises a crystalline grain.

6. A device according to claim 5, wherein the crystalline grain has a diameter of 30 nm or less.

7. A device according to claim 5 or 6, wherein the crystalline grain has a diameter of 20 nm or less.

8. A device according to claim 5, 6 or 7, wherein the crystalline grain has a diameter of 10 nm or less.

9. A device according to any one of claims 4 to 8, wherein the crystalline grain has a diameter between 4 to 8 nm.

10. A device according to any one of claims 4 to 9, wherein the crystalline grain is columnar.

11. A device according to any one of claims 4 to 9, wherein the crystalline grain is substantially spherical.

12. A device according to any one of claims 5 to 11, comprising a further crystalline grain.

13. A device according to any preceding claim, wherein the crystalline conductive region (9) comprises semiconductor material.

14. A device according to any preceding claim, wherein the crystalline conductive region (9) comprises silicon.

15. A device according to claim 13 or 14, wherein the crystalline conductive region (9) is doped with an impurity.

16. A device according to claim 15, wherein the impurity is an electron donor.

17. A device according to claim 16, wherein the donor is phosphorous.

18. A device according to claim 16, wherein the donor is arsenic.

19. A device according to any one of claim 15 to 18, wherein the impurity is doped to a concentration of 1×10¹⁹cm⁻³ or above.

20. A device according to claim 19, wherein the impurity is doped to a concentration of 1×10²⁰cm⁻³ or above.

21. A device according to any preceding claim, wherein the amorphous insulating region (10) comprises a material comprising silicon atoms.

22. A device according to claim 21, wherein the material further comprises oxygen atoms.

23. A device according to claim 22, wherein oxygen atoms comprise at least 25% of the material.

24. A device according to claim 22 or 23, wherein oxygen atoms comprise no more than 67% of the material.

25. A device according to any one of claims 21 or 22, wherein the material further comprises nitrogen atoms.

26. A device according to claim 25, wherein nitrogen atoms comprise at least 50% of the material.

27. A device according to any one of claims 21, 22 or 25, wherein the material further comprises carbon atoms.

28. A device according to claim 27, wherein carbon atoms comprise at least 50% of the material.

29. A device according to claim 21, 22, 25 or 27, wherein the material further comprises hydrogen atoms.

30. A device according to claim 29, wherein hydrogen atoms comprise at least 2% of the material.

31. A device according to any preceding claim, wherein the channel (2) is arranged as a layer (6).

32. A device according to claim 31, wherein the layer (6) has a thickness of 30 nm.

33. A device according to claim 31 or 32, wherein the layer (6) is continuous.

34. A device according to any preceding claim, wherein the channel (2) is less than 50 nm long and 50 nm wide.

35. A device according to claim 34, wherein the channel (2) is less than 30 nm wide.

36. A device according to any preceding claim, wherein the channel (2) includes a further crystalline conductive region (9), wherein the amorphous insulating region (10) is disposed between the crystalline conductive regions (9).

37. A device according to claim 36, wherein the amorphous insulating region (10) forms a matrix.

38. A device according to any preceding claim, further comprising a source (3) and a drain (4) disposed at either end of the channel (2).

39. A device according to claim 38 further comprising a gate electrode (5).

40. A device according to claim 39, wherein the gate electrode (5) is configured as a side gate.

41. A memory device comprising a device according to any preceding claim.

42. A memory device according to claim 41, further comprising a metal-oxide-semiconductor field effect transistor (MOSFET).

43. A logic device comprising a device according to any one of claims 1 to 40.

44. A method of fabricating a correlated charge transfer device (1) which includes a conductive channel (2) comprising a crystalline conductive region (9) and an amorphous insulating region (10) configured to form a potential barrier relative to the conductive region whereby to allow the device to exhibit Coulomb blockade, the method **characterised by**
treating the amorphous insulating region so that it exhibits a tunnel barrier height of at least 100 meV.

45. A method according to claim 44, wherein the treatment comprises preferentially introducing a reagent into the amorphous insulating region (10) over the crystalline conductive region (9).

46. A method according to claim 45, wherein the preferential introduction of the reagent into the amorphous insulating region (10) over the crystalline conductive region (9) comprises preferentially oxidizing the amorphous insulating region over the crystalline conductive region.

47. A method according to any one of claims 45 or 46, wherein the treatment further comprises annealing the amorphous insulating region (10).

48. A method according to claim 44, wherein the treatment comprises preferentially oxidizing the amorphous insulating region (10) over the crystalline conductive region (9) and annealing the amorphous insulating region.

49. A method according to claim 48, wherein the preferential oxidization is performed at a relatively low temperature and the annealing is carried out at a relatively high temperature.

50. A method according to claim 48 or 49, wherein the oxidization is performed between 500 and 800 °C.

51. A method according to claim 50, wherein the oxidization is performed at about 750 °C.

52. A method according to any one of claims 48 to 51, wherein the annealing is carried out at between 900 and 1100 °C.

53. A method according to claim 52, wherein the annealing is carried out at about 1000 °C.

54. A method according to claim 44, wherein the treatment includes using O₂, H₂O or H₂O₂.

55. A method according to claim 44 or 54, wherein the treatment includes using N₂, NH₃, N₂O, NO, NO₂ or HCN.

56. A method according to claim 44, 54 or 55, wherein the treatment includes using C, CO or CO₂.

57. A method according to any one of claims 44 to 56, further comprising providing a substrate and depositing a film (6') over the substrate comprising the conductive crystalline (9) and amorphous insulating regions (10).

58. A method according to claim 57, wherein the depositing of the film (6') comprises mixing halogenated silane, silane and hydrogen feed gases.

59. A method according to claim 58, wherein the mixing of the feed gases comprises using a ratio of halogenated silane to hydrogen equal or less than 1.

60. A method according to any one of claims 57 to 59, wherein the depositing a film (6') comprises heating the substrate to at least 300 °C.

61. A method according to any one of claims 57 to 60, further comprising patterning the film (6') to define the conductive channel (2).

62. Apparatus for performing the method according to any one of claims 44 to 61.
